Europäisches Patentamt

European Patent Office

Office européen des brevets

(11) Publication number: **0 358 251**
**A1**

(12) **EUROPEAN PATENT APPLICATION**

(21) Application number: **89202025.6**

(51) Int. Cl.⁵: **H05K 9/00**

(22) Date of filing: **03.08.89**

(30) Priority: **26.08.88 BE 8800976**

(43) Date of publication of application:
**14.03.90 Bulletin 90/11**

(84) Designated Contracting States:
**AT BE CH DE ES FR GB GR IT LI LU NL SE**

(71) Applicant: **BAETEN N.V.**
**Autostradeweg**
**B-9230 Melle(BE)**

(72) Inventor: **Persoons, Luc**
**Scheldestraat 25**
**B-9730 Nazareth(BE)**
Inventor: **De Cock, Johan**
**Park ter Kouter 12**
**B-9210 Heusden(BE)**

(74) Representative: **Pieraerts, Jacques et al**
**Bureau Gevers S.A. rue de Livourne 7 bte 1**
**B-1050 Bruxelles(BE)**

(54) **A shielded chamber.**

(57) A shielded chamber provided with a transit aperture in which a transit casing is applied wherein a detachable transit member is applied for realizing a connection between an inside and an outside of said chamber. An aperture is provided on a wall of the transit casing situated on an inside of the chamber and on which said connection is established, in which aperture there is applied a first stand-up collar, and wherein on the transit member a second stand-up collar is applied which fits with said first stand-up collar, and in that in a space between said first and second stand-up collars a first resistance element is applied for attenuating electromagnetic radiation.

Fig.1.

# A shielded chamber

The invention relates to a shielded chamber provided with a transit aperture in which a transit casing is applied wherein a detachable transit member is applied for realizing a connection between the inside and the outside of the chamber.

Such a shielded chamber is known from the prospectus "Einbausatzprogramm 3. Elektrischer Teil", in particular § 3.4. "Anschaltskasten für Signalübertragung", published in January 1979 by the company Dornier. Such a chamber can for example be used as an atomic air-raid shelter or as another EMP-Tempest shielded chamber. The contact with the outer world is realized by means of a detachable transit member which is fitted in a transit casing. In order to attenuate electromagnetic radiation which propagates in the connection space between the transit casing and the outer wall of the chamber, a resistance element is provided in that connection room. The transit member is for example formed by a filter via which an electrical signal is inputted. The transit casing can also comprise an air-filter.

In order not to enable radiation to come in through that transit casing and through that transit member, that transit member has to be EMP-Tempest shielded, even as the transit casing and the transit member which have to be tightly EMP-Tempest mounted.

A drawback of the known shielded chambers is that by using detachable transit members the serial connection of the transit resistances between the chamber, the transit casing and the transit member affects the shielding in such a manner that the requirement of EMP-Tempest tightness can no longer be satisfied. When thereupon the transit member comprises several modules that thightness is still more affected. Indeed by the known devices there is practically no shielding provided between the different parts at the inner side of the chamber.

It is an object of the invention to realize a shielded chamber wherein, by making use of a detachable transist member, enough protection is still provided in order to satisfy the requirements of EMP-Tempest tightness.

A shielded chamber according to the invention is therefore characterized in that an aperture is provided on a wall of the transit casing situated on the inside of the chamber and on which said connection is established, in which aperture there is supplied a first stand-up collar, and wherein on the transit member a second stand-up collar is applied which fits with said first stand-up collar, and in that a space between said first and second stand-up collars a first resistance element is applied for attenuating the electromagnetic radiation.

Radiation which has now penetrated between the transit casing and the transit member is prevented to penetrate inside the shielded chamber thanks to the further resistance element in the space between the collars. The fact that the transit casing self is provided with a second collar which fits with the first collar, provides that, even with detachable members, there is always formed, thanks to the presence of the further resistance element, an EMP-Tempest tight connection.

A preferred embodiment of a shielded chamber according to the invention is characterized in that a cover is applied on said wall situated at the inner side of the chamber in which cover said first stand-up collar is applied, and in that between said cover and the transit casing a second resistance element for attenuating electromagnetic radiation is applied. This further improves the shielding between the cover and the transit casing.

By using a required transit casing, a shielded chamber according to the invention is characterized in that the further transit casing is included in said transit casing, and wherein a third resistance element for attenuating the electromagnetic radiation is applied in the neighbourhood of a further connection between the transit casing and the next transit casing, which further connection is situated at the height of the connection between the outer wall of the chamber and the transit casing. According to this a solution is realized which, on the one hand, is compatible with the required transit casing and, on the other hand, satisfies the high requirements with respect to EMP-Tempest shielding.

The invention will now be described by means of the embodiments represented in the drawing. It will be clear that the invention is not limited to the embodiments shown in the drawing and that within the scope of the invention several embodiments are possible.

In the drawing:

Figure 1 shows a cross-section of a shielded chamber according to the invention.

Figure 2 shows a cover which has to be applied on a transit casing.

Figure 3 shows a transit member provided with a stand-up collar.

Figure 4 shows a cross-section of a further shielded chamber according to the invention.

In the drawings same reference numbers relate to analogous elements.

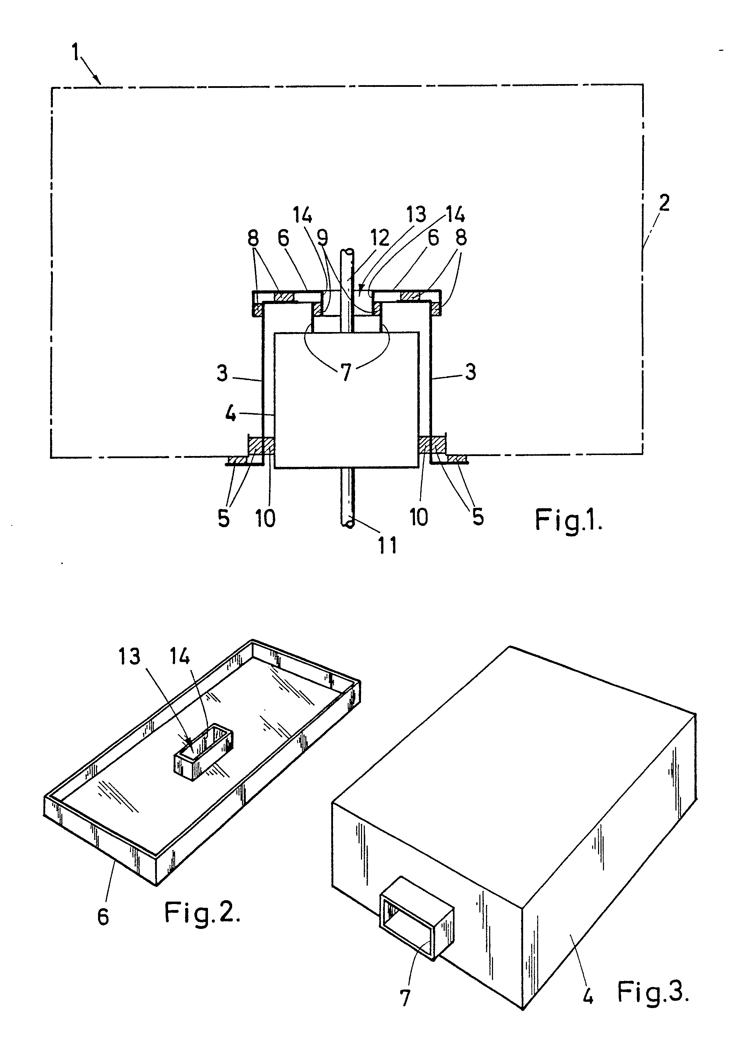

The inner side of the shielded chamber 1 represented in Figure 1 is surrounded by a wall 2. A transit casing 3 is applied in an aperture of that wall. A resistance element 5 for attenuating the electromagnetic radiation is applied at the height of a connection between the outer wall of the chamber and the transit casing. In order to apply the resistance element 5 over a sufficient surface as well the wall 2 as the transing casing are provided with a bended border at the height of that connection.

It is also possible to rigidly connect the transit casing 3 with the outer wall, for example by welding the transit casing to the outer wall of the chamber. In the latter case it is then not necessary, if a tight connection is formed by the welding, to apply a resistance element.

The resistance element 5 is for example formed by a metallic spring contact and/or a gasket. The gasket is of the type "all-mesh" as for example described in the prospectus "RFI-Schielding" of the manufacturer RFI-Schielding Ltd., Braintree (Essex). The gasket comprises a flexible kernel for example made of rubber or of an rust-proof spring, which is surrounded with at least one layer of a metallic fabric. The gasket is for example applied between two rubbers, for example neopren rubbers, which comprises a self adhesive side and thus hold the gasket in its place. Such a gasket has the advantage that beside its flexibility it forms an excellent EMP-Tempest shielding.

In the transit casing 3 there is applied a transit member 4, for example an electrical filter unit provided with an input11 and an outputline 12 respectively. The transit member can also be provided with an air filter or another unit. Preferably a resistance element 10 is applied at the input of the split between the transit member 4 and the transit casing 3, which resistance element also serves for attenuating electromagnetic radiation.

The back wall of the transit casing 3, that is the wall which is at the inner side of the shielded chamber, is provided with an aperture 13. The aperture 13 serves to establish a connection between the transit member 4 and the inner side of the room 1. Preferably a cover 6 is applied in that aperture 13, as represented in figure 1. It is also possible that the back wall forms a whole with the side walls of the transit casing. In the latter the opening 13 is directly applied on a back wall of the transit casing.

The cover or the back wall, in function of the chosen embodiment, is provided at the height of the aperture 13 with a first stand-up collar 14 (figure 2) which extends in the inner side of the transit casing. Between the cover 6 and the back wall of the transit casing there is applied a resistance element 8 which is also formed by a spring contact and/or a gasket. Here also the extremities of the cover 6 and the transit casing 6 are bended in order to provide a better tightening and a larger contact surface for the resistance element.

On the back wall of the transit member a second stand-up collar 7 (figure 3) is applied. That second stand-up collar preferably has a length which is larger than the one of the first collar 14 applied on the cover 6. In the space between the stand-up collars 15 and 7 a further resistance element 9 is applied which is also formed by a spring contact and/or gasket. It will be clear that the length of the collar 7 can also be smaller than the one of the collar 14. Whatever may be the dimension of that diameter, it is important that both collars fit with each other and that in the space between those collars a further resistance element is applied in order to prevent the leaking away of electromagnetic radiation through that space.

Suppose now that electromagnetic radiation has leaked through the transit member 4 inside the space between the transit casing 3 and the transit member 4. That radiation can now impossibly reach the inner side of the chamber 1 because the resistance element 8 prevent the leakage between the cover 8 and the transit casing, and the further resistance element 9 prevent the leakage between the cover 8 and the second collar 7 of the transit member. The use of spring contacts and/or gaskets for the resistance element 8 provide that the transit member can be demountably mounted. Indeed by plugging in the transit member 4 in the transit casing, the spring contact and/or the gasket 9 provides that thanks to their spring characteristics a good shielding is provided.

Due to the fact that the shielding is now completely realized by means of the resistance elements in combination with the cover 6 (if present), the transit casing and the collar 7, the EMP attenuation is now completely independent of an eventual filter in the transit member 4 and the mounting of the transit member.

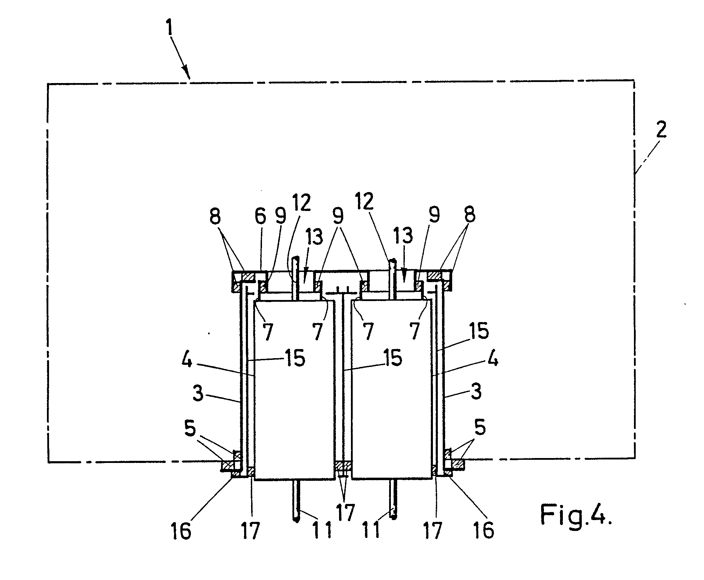

The transit casing can either comprise a transit member, as represented in figure 1, or several transit members as represented in figure 4, where two transit members are fitted in the transit casing. In the case that several transit members being mounted in the transit casing, the cover is each time provided with as much apertures as there are transit members and each aperture respectively each transit member, is provided with collars which fit with each other and a resistance element is each time applied in the space between the collars.

When the authorities or the Army impose a predeter mined type of transit casing such as for example the transit casing of the type BJ, that required transit casing 15 is mountened in the transit casing 3 according to the invention, as illustrated in figure 4. At the front side the predescribed transit casing 16 is connected by means of resistance elements 16 respectively 17 with the transit casing and respectively with the transit member 4. The cover 6 covers completely the required transit casing 16, in such a manner that radiation which has leaked in the space between the transit member 4 and the required transit casing is prevented to leak inside the shielded chamber due to the presence of the resistance elements 7 and 8. The system is thus completely compatible with the required transit casings.

## Claims

1. A shielded chamber provided with a transit aperture in which a transit casing (3) is applied wherein a detachable transit member (4) is applied for realizing a connection between the inside and the outside of the chamber, characterized in that an aperture (13) is provided on a wall of the transit casing situated on the inside of the chamber and on which said connection is established, in which aperture there is applied a first stand-up collar (14), and wherein on the transit member a second stand-up collar (7) is applied which fits with said first stand-up collar, and in that in a space between said first and second stand-up collars a first resistance element (9) is applied for attenuating electromagnetic radiation.

2. A shielded chamber as claimed in claim 1, characterized in that a cover (6) is applied on said wall situated at the innerside of the chamber in which cover said first stand-up collar is applied, and in that between said cover (6) and the transit casing a second resistance element (8) for attenuating electromagnetic radiation is applied.

3. A shielded chamber as claimed in claims 1 or 2, wherein a further transit casing has to satisfy predetermined requirements, characterized in that, the further transit casing (15) is included in said transit casing (3) and wherein a third resistance element (17) for attenuating the electromagnetic radiation is applied in the neighbourhood of a further connection between the transit casing and the further transit casing, which further connection is situated at the height of the connection between the outer wall of the chamber and the transit casing.

4. A shielded chamber as claimed in claim 2, characterized in that the border of the cover and the border of the transit casing are bend, and that said second resistance element (8) is mounted in the space between the bended parts.

5. A shielded chamber as claimed in anyone of claims 1 to 4, characterized in that the surface surrounded by the first collar (15) is smaller than the surface surrounded by the second collar (7).

6. A transit casing to be used in a shielded chamber as claimed in anyone of claims 1 to 5, characterized in that on said wall situated at the inner side of the chamber there is applied an aperture (13) in which a first stand-up collar (15) is applied.

7. A transit casing to be used in a shielded chamber as claimed in anyone of claims 1 to 5, characterized in that the transit casing is provided with a cover (6) having an aperture wherein a first stand-up collar (15) is applied.

8. A cover to be used in a shielded chamber as claimed in one of the claims 2 or 4, characterized in that the cover (6) is provided with an aperture in which a first stand-up collar (14) is applied.

9. A transit member to be used with a shielded chamber as claimed in anyone of claims 1 to 5, characterized in that on the transit member a second stand-up collar (7) is applied.

Fig.1.

Fig.2.

Fig.3.

Fig.4.

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 5) |
|---|---|---|---|
| A | DE-A-2 743 093 (GENERAL ELECTRIC CO.) * page 5, paragraph 1; page 6, paragraph 1; page 14, paragraph 1 - page 15, paragraph 2; figures 3,4 * | 1,2,6-8 | H 05 K 9/00 |
| A | GB-A-2 184 293 (GEC AVIONICS LTD.) * page 1, lines 87-105; figure 1 * | 1 | |
| A | US-A-4 115 656 (M. L. AITEL) * column 6, lines 23-30; figure 2 * | 4 | |

TECHNICAL FIELDS SEARCHED (Int. Cl.5)

H 05 K 9/00

The present search report has been drawn up for all claims

| Place of search | Date of completion of the search | Examiner |
|---|---|---|
| BERLIN | 24-11-1989 | ALEXATOS G |

EPO FORM 1503 03.82 (P0401)